# EUROPÄISCHE PATENTSCHRIFT

(11) **EP 0 541 913 B1**
(45) Veröffentlichungstag und Bekanntmachung des Hinweises auf die Patenterteilung: **12.06.1996**
(21) Anmeldenummer: 92114283.2
(22) Anmeldetag: 21.08.1992
(51) Int. Cl.: B01J 3/00, G02B 23/16, G02B 7/00

(54) **Vorrichtung zum Beobachten von Prozessabläufen**
Device for observing the course of processes
Dispositif d'observation du déroulement de processus

(30) Priorität: 14.11.1991 DE 4137414
(43) Veröffentlichungstag der Anmeldung: 19.05.1993
(73) Patentinhaber: LEYBOLD AKTIENGESELLSCHAFT, D-63450 Hanau (DE)
(72) Erfinder: Wenk, Karl-Heinrich, W-6360 Bad Nauheim 6 (DE)
(74) Vertreter: Sartorius, Peter, Dipl.-Ing. Patentanwalt

(56) Entgegenhaltungen:
- FR-A- 1 367 114
- GB-A- 1 120 030

## Beschreibung

Die Erfindung betrifft eine Vorrichtung zum Beobachten von Prozeßabläufen mit den Merkmalen gemäß dem Oberbegriff des Patentanspruchs 1.

Es ist bereits allgemein bekannt, bei einem Schauglas eine Handblende vorzusehen, bei der die Gefahr besteht, daß durch längeres Öffnen der Blende eine starke Verschmutzung des Schauglases eintritt, so daß dann der Prozeßablauf bzw. der Bedampfungsvorgang nicht mehr beobachtet werden kann.

Hierzu ist es bekannterweise möglich, das Beobachtungsschauglas vor dem Bedampfungsvorgang mit Öl einzustreichen, um es vor dem Bedampfen zu schützen. Dies ist vakuumtechnisch umstritten bzw. sehr problematisch, insbesondere weil dadurch die Durchsicht beinträchtigt wird und dies auch zu Verunreinigungen am Substrat führen kann.

Es ist bereits eine Vorrichtung zum Beobachten von Prozeßabläufen in der Vakuumtechnik bekannt (D1 GB-A-1 120 030), bei der ein scheibenförmiger, Schlitzöffnungen aufweisender Rotor vorgesehen ist, der über einen Motor angetrieben wird. Die in der Scheibe vorgesehenen schlitzförmigen Öffnungen weisen alle die gleiche Querschnittsöffnung auf. Das hat zur Folge, daß die Person, die den Prozeßablauf innerhalb der Vakuumanlage beobachten muß, genau auf der Höhe des Schlitzes nur einen kleinen Ausschnitt in der Prozeßkammer sehen kann. Sollen beispielsweise mehrere nebeneinander liegende Objekte beobachtet werden, so ist das mit einer derartigen Scheibe nicht möglich. Deshalb wurden in der Vergangenheit bei dem Einsatz derartiger Scheiben mehrere derartige Beobachtungsvorrichtungen nebeneinander in den Vakuumanlagen installiert, um einen besseren Überblick über den gesamten Prozeßablauf bzw. über nebeneinander liegende Objekte zu erhalten.

Es ist jedoch auch nicht möglich, derartige Scheiben beliebig zu vergrößern, da dadurch ein sehr großer Platzbedarf entsteht. Trommelartige Rotoren können jedoch einen relativ kleinen Durchmesser haben und ohne weiteres in ihrer Breite verlängert werden, ohne daß hierdurch wesentlich mehr Platz benötigt wird, als es vergleichsweise bei Rotorscheiben erforderlich wäre. Ferner setzen sich die lediglich in einer Ebene liegenden Schlitze derartiger Rotorscheiben wesentlich schneller zu als die Öffnungen bei Rohrstroboskopen.

**Demgegenüber besteht die Erfindungsaufgabe darin**, eine wirtschaftlich einfache Vorrichtung zu schaffen, durch die Prozeßabläufe insbesondere in einer Vakuumkammer über ein Schauglas über einen längeren Zeitraum hinweg ungehindert beobachtet werden können, wobei die hierzu erforderliche Vorrichtung auf einfachste Weise angetrieben wird.

**Diese Aufgabe wird durch** die im Patentanspruch 1 aufgeführten Merkmale gelöst. Durch die rotierende Vorrichtung zur Verhinderung von Verschmutzung des Schauglases läßt sich der Prozeßablauf in der Vakuumkammer über einen sehr langen Zeitraum ungehindert beobachten, ohne daß zu befürchten ist, daß das Schauglas verschmutzt. Durch die vorteilhafte Anordnung der beiden unterschiedlich großen Schlitzöffnungen ist es nunmehr erstmals möglich, daß die Bedienungsperson ein wesentlich größeres Gesichtsfeld zur Beobachtung der Prozeßabläufe erhält, auch dann, wenn sie sich vor dem Schauglas auf- und abbewegt. Die unterschiedlich großen Schlitzöffnungen verhindern somit den normalerweise auftretenden Grauschleier, wie es bei den bekannten Vorrichtungen der Fall ist. Da das in die Vakuumkammer eingeführte Inertgas gleichzeitig auch als Antriebsmittel für die Vorrichtung eingesetzt werden kann, läßt sich die Vorrichtung insgesamt wesentlich kostengünstiger herstellen als bisher.

Ferner ist es vorteilhaft, daß die Antriebsvorrichtung aus mindestens einer als Schaufelrad ausgebildeten Antriebsscheibe und einer Strahldüse besteht, die Inertgas auf die Antriebsscheibe leitet.

In weiterer Ausgestaltung der Erfindung ist es vorteilhaft, daß in Umfangsrichtung des Rohrstroboskops die Eingangsöffnung mindestens 0,5 mm und die Ausgangsöffnung zwischen 1 und 50 mm groß ist. Durch die relativ kleine Öffnung wird eine Verschmutzung des Schauglases wirksam verhindert. Durch den großen Schlitz auf der Ausgangsseite erhält man ein entsprechend großes Gesichtsfeld.

Eine zusätzliche Möglichkeit ist gemäß einer Weiterbildung der erfindungsgemäßen Vorrichtung, daß die Strahldüse mit Bezug auf die Drehachse des Rohrstroboskops und/oder der Antriebsscheibe geneigt verlaufend angeordnet ist. Hierdurch wird eine sehr kostengünstige, leicht zu installierende Vorrichtung zum Antrieb des Rohrstroboskops geschaffen. Für die Strahlentgasung wäre es denkbar, ein Rohrstroboskop einzusetzen, welches nur mit Hilfe von Argongas angetrieben wird, also ohne Elektromotor läuft (Argonstrahlantrieb). Der Vorteil dieser Vorrichtung wäre ein gewisser Überdruck an Argon im Rohrstroboskop selbst. Dieses Argonpolster wirkt zusätzlich einer starken Verschmutzung des Schauglases entgegen.

In weiterer Ausgestaltung der Erfindung ist es vorteilhaft, daß im Bereich des Schauglases und/oder des Rohrstroboskops eine Absaugvorrichtung vorgesehen ist, über die Schmutzpartikel aus dem Aufnahmeraum des Rohrstroboskops absaugbar sind. Hierdurch kann die Standzeit des Stroboskops erhöht werden bzw. verhindert werden, daß sich das Schauglas schon nach kurzer Zeit zusetzt.

Ferner ist es vorteilhaft, daß der Abstand zwischen dem Außenumfang des Rohrstroboskops und der Schauglas-Innenoberfläche mindestens 1 mm groß ist.

Vorteilhaft ist es ferner, daß das Rohrstroboskop aus einem zylinderförmigen Rohrmantel besteht, an dessen Enden sich je eine Scheibe mit einer Nabe befindet, die in in Flanschen vorgesehenen Lagern drehbar aufgenommen sind.

Eine mögliche Variante dieser Vorrichtung ist der Einbau direkt an einem Vakuumkessel mit Normteilen. Diese Vorrichtung befindet sich beispielsweise in Bedampfungsanlagen, bei denen Folien mit hohen Umwickelgeschwindigkeiten einer Bedampfungsquelle zugeführt und mit Aluminium bedampft werden.

In weiterer Ausgestaltung der Erfindung ist es vorteilhaft, daß das Rohrstroboskop bzw. die zugehörigen Teile des Rohrstroboskops mit Auswuchtbohrungen versehen sind.

**Vorteile und Einzelheiten der Erfindung sind in den Patentansprüchen** und in der Beschreibung ausgeführt und in den Figuren dargestellt. Es zeigt:
- Figur 1: eine schematische Darstellung eines Rohrstroboskops in einer Vakuumbandbeschichtungsanlage im Querschnitt,
- Figur 2: die im Rohrstroboskop vorgesehenen Öffnungen zur Betrachtung der Arbeitsabläufe,
- Figur 3: ein zweites Ausführungsbeispiel eines auf Wälzlagern drehbar gelagerten Rohrstroboskops mit Vakuumdrehdurchführungen als Lagerteil im Längsschnitt,
- Figur 4a: eine Rückansicht gemäß Figur 3 mit der zugehörigen Antriebsscheibe und einen Teilschnitt der Antriebsscheibe,
- Figur 4b: einen Teilschnitt nach 4b-4b gemäß Figur 4a.

In der Zeichnung ist mit 1 eine Vakuumanlage bzw. ein Vakuumkessel bezeichnet, der aus einer zylinderförmig ausgebildeten Rohranlage 20 bestehen kann. An dem Vakuumkessel 1 befindet sich ein rechteckiger Fußteil 21, mit dem der Vakuumkessel 1 auf dem Boden abgestellt ist.

Etwas unterhalb einer horizontal verlaufenden Mittelebene 23 ist ein mit Bezug auf die Abstellfläche des Vakuumkessels 1 geneigt verlaufender Schauglaskasten 2 an dem Vakuumkessel 1 angebracht, mit dem man beispielsweise über ein am Schauglaskasten 2 angebrachtes Schauglas 3 in den Vakuumkessel 1 hineinsehen und ein Verdampferschiffchen 40 bzw. andere im Vakuumkessel 1 vorgesehene Teile bzw. Prozeßabläufe gut beobachten kann.

Der Schauglaskasten 2 besteht aus einem zylinderförmigen Rohr 4' zur Aufnahme eines Rohrstroboskops 4, das aus einem zylinderförmigen Rohrmantel 41 besteht, an dessen Enden sich je eine Scheibe 5 mit einer Nabe 34 befindet. Das Rohr 4' weist rechts und links unmittelbar neben dem Schauglas 3 zwei Flansche 8 auf, die koaxial angeordnet sind und spiegelsymmetrisch zum Schauglaskasten 2 verlaufen. Die Flansche 8 sind an dem Rohr 4' fest angeordnet bzw. angeschweißt oder auf andere Weise mit diesem verbunden.

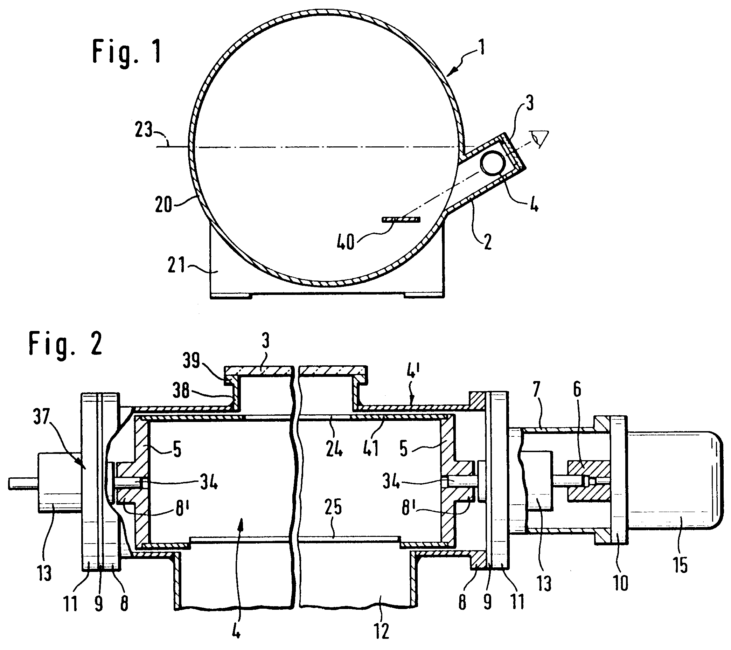

Mittig zwischen den beiden Flanschen 8 sitzt in dem Rohr 4' das Rohrstroboskop 4, das den gesamten Zwischenraum zwischen den beiden Flanschen 8 ausfüllt. Das Rohrstroboskop 4 besitzt mindestens ein, vorzugsweise zwei oder auch mehrere gegenüberliegende, kleine Beobachtungsöffnungen bzw. Längsschlitze 24, 25 (vgl. Figur 2).

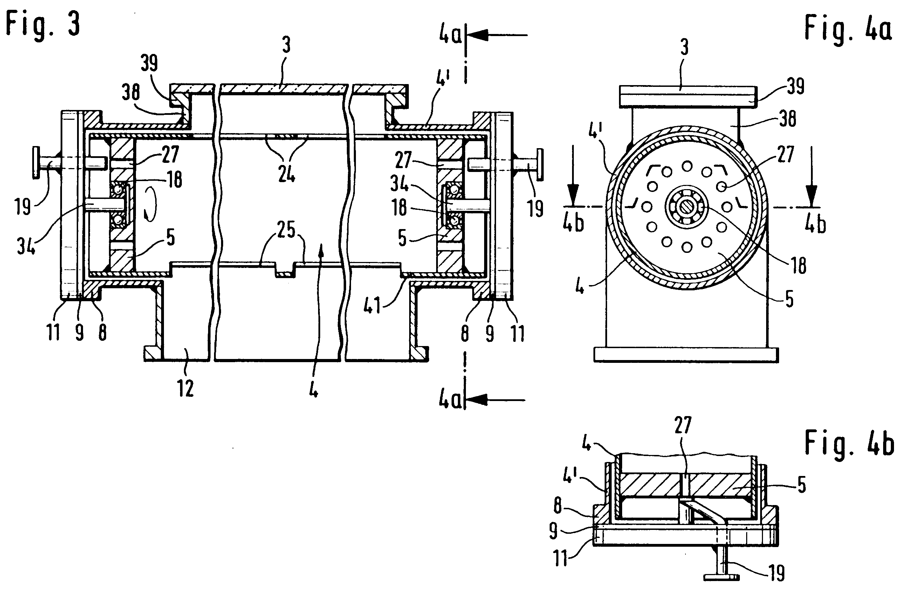

Am Ende des Rohrstroboskops 4 (Figur 3) befinden sich koaxial angeordnete Rohransätze mit je einer Aufnahmescheibe 5, die mit dem Rohrstroboskop 4 verschweißt bzw. fest verbunden sind. Die Lagerung dieses Rohrstroboskops 4 erfolgt über nicht dargestellte Vakuumdrehdurchführungen. Die Abdichtung der am Rohr 4' endseitig vorgesehenen Flansche 8 und der zugehörigen Flansche 11 erfolgt über je eine zwischen den Flanschen 8, 11 vorgesehene Vakuumdichtung 9.

Mit Bezug auf Figur 3 ist an dem oberen Ende eines Rohrstutzens 38 ein Flansch 39 vorgesehen, auf dem das Schauglas 3 dichtend befestigt ist.

Wie aus Figur 3 ferner hervorgeht, ist diametral gegenüber dem Rohrstutzen 38 ein T-Stück 12 mit der Nennweite 100 mm vorgesehen, das dem zylinderförmigen Außenumfang des Kessels 1 angepaßt ist, damit das T-Stück 12 relativ dicht an die Rundung bzw. an den Außenumfang des Kessels 1 gemäß Figur 1 herangeführt werden kann.

Zwischen dem Schauglas 3 und dem Flansch 39 sowie dem T-Stück 12 ist das Rohrstroboskop 4 vorgesehen, das, wie bereits erwähnt, mit zwei gegenüberliegenden Längsschlitzen 24, 25 gemäß Figur 2 versehen ist. Der eingangsseitige Längsschlitz 24 sollte mindestens 0,5 mm groß sein, während der ausgangsseitige Längsschlitz 25 größer, beispielsweise zwischen 1 mm und 50 mm groß, sein sollte. Auf diese Weise wird verhindert, daß sich auf dem Schauglas 3 ein Schmutzfilm bildet, da die Schmutzpartikel nunmehr hauptsächlich auf dem zylinderförmigen Rohrstroboskop 4 abgeschieden werden können.

Die Lagerung des Rohrstroboskops 4 kann über Vakuumdrehdurchführungen erfolgen, die wiederum mittig in den Flanschen 11 sitzen. Der Flansch 11 kann einen Durchmesser zwischen 100 und 150 mm, insbesondere 130 mm, aufweisen. Hierdurch erhält man hinter dem Schauglas 3 für das Rohrstroboskop 4 eine sehr platzsparende Anordnung.

Im Ausführungsbeispiel gemäß Figur 3 können die Lager als Gleitlager, insbesondere als Rillenkugellager 18, ausgebildet sein.

Die beiden aus Al bestehenden Flansche 11 sind ebenfalls mit den Vakuumdichtungen 9 gegen die Flansche 8 verschlossen. Hierzu sind die Flansche 11 an die Flansche 8 angeschraubt und somit gegen Atmosphäre abgedichtet.

In den beiden Aufnahmescheiben 5 des Rohrstroboskops 4 befinden sich (gemäß Figur 3 und 4a) auf einem Teilkreis zahlreiche Öffnungen 27, durch die ein Gas, beispielsweise Argongas, in das Innere des Stroboskopraums strömen kann.

Der Antrieb des Rohrstroboskops 4 erfolgt über die als Schaufelrad ausgebildete Aufnahmescheibe 5. Wie aus Figur 3 hervorgeht, wird das Schaufelrad mit einem Gasstrahl beschickt, der durch in den Blindflanschen 11 vorgesehene Strahldüsen 19 (vgl. Figur 4b) und die Öffnungen 27 geleitet wird, die in der Scheibe 5 vorgesehen sind. Hierdurch wird eine Drehung des Rohrstroboskops 4 auf sehr kostengünstige Weise herbeigeführt. Um Unwuchten auszugleichen, können die drehenden Teile, insbesondere die Scheibe 5, mit Ausgleichsbohrungen versehen sein.

Das Rohrstroboskop 4 kann mit einer Absaugvorrichtung versehen sein, um bei sehr starker Bedampfung sicherzustellen, daß der Staub bzw. die Schmutzpartikel abgesaugt werden, die sich sonst auf dem Schauglas 3 ablagern würden.

Mit dieser Vorrichtung lassen sich die Verdampferschiffchen 40 oder Prozeßabläufe insbesondere für die Aufdampftechnik in Vakuumprozessen ohne weiteres beobachten.

Anstelle der Schlitze 24, 25 gemäß Figur 2 können auch mehrere Schlitze in dem Rohrstroboskop 4 diametral gegenüberliegend angeordnet bzw. auf einer Längsmittelebene 29 nebeneinander vorgesehen sein. Auf diese Weise können auch mehrere Personen gleichzeitig den Prozeß über das Rohrstroboskop 4 beobachten. Die Schlitzgröße bzw. die besondere Ausbildung der Schlitze 24, 25 kann unter Berücksichtigung des Verfahrens und der Anlage variiert werden.

### Bezugszeichenliste

- 1: Vakuumanlage bzw. Vakuumkessel
- 2: Schauglaskasten
- 3: Schauglas
- 4: Rohrstroboskop
- 4': Rohr
- 5: Aufnahmescheibe, Antriebsscheibe, Scheibe
- 6: Kupplung
- 7: Rohransatz bzw. Rohr
- 8: Flansch
- 8': Rohransatz
- 9: Vakuumdichtung
- 10: Flansch
- 11: Flansch
- 11': Flansch
- 12: T-Stück
- 13: Vakuumdrehdurchführung
- 15: Motor
- 16: Magnetkupplung
- 16': Teil der Magnetkupplung
- 16'': Teil der Magnetkupplung
- 18: Rillenkugellager
- 19: Strahldüse
- 20: Rohranlage
- 21: Fußteil
- 23: Mittelebene
- 24: Längsschlitz, Eingangsöffnung
- 25: Längsschlitz, Ausgangsöffnung
- 27: Öffnung, Zapfen
- 29: Längsmittelebene
- 31: Vakuumkammer
- 34: Nabe
- 35: Achse
- 36: Mittelachse
- 37: Gleitlager
- 38: Rohrstutzen
- 39: Flansch
- 40: Verdampferschiffchen
- 41: Rohrmantel

## Patentansprüche

1. Vorrichtung zum Beobachten von Prozeßabläufen, insbesondere von Prozeßabläufen in der Vakuumtechnik mit einem hinter einer Kammer angeordneten Schauglas (3), an dem ein zylindrischer, rohrförmiger Körper, der ein Rohrstroboskop (4) bildet, zur Verhinderung von Verschmutzung des Schauglases (3) rotierend vorbeibewegt wird, in dem mindestens zwei diametral gegenüberliegende schlitzförmige Öffnungen (24, 25) auf gleicher Ebene vorgesehen sind, wobei das Rohrstroboskop (4) über einen außerhalb der Vakuumkammer vorgesehenen Motor oder eine ein gasbetriebenes Antriebsrad (5) aufweisende Antriebsvorrichtung antreibbar ist und daß die auf der einen Seite des Rohrstroboskops (4) angeordnete Öffnung eine Eingangsöffnung (24) mit einem Durchsehquerschnitt bildet, der wesentlich kleiner ist als der Durchsehquerschnitt der auf der anderen Seite diametral gegenüberliegenden Ausgangsöffnung (25).

2. Vorrichtung nach Anspruch 1**, dadurch gekennzeichnet**, daß die Antriebsvorrichtung aus mindestens einer als Schaufelrad ausgebildeten Antriebsscheibe (5) und einer Strahldüse (19) besteht, die Inertgas auf die Antriebsscheibe (5) leitet.

3. Vorrichtung nach Anspruch 1, **dadurch gekennzeichnet**, daß in Umfangsrichtung des Rohrstroboskops (4) die Eingangsöffnung (24) mindestens 0,5 mm und die Ausgangsöffnung (25) zwischen 1 und 50 mm groß ist.

4. Vorrichtung nach einem oder mehreren der vorhergehenden Ansprüche, **dadurch gekennzeichnet**, daß die Strahldüse (19) mit Bezug auf die Drehachse des Rohrstroboskops (4) und/oder der Antriebsscheibe (5) geneigt verlaufend angeordnet ist.

5. Vorrichtung nach einem oder mehreren der vorhergehenden Ansprüche, **dadurch gekennzeichnet**, daß im Bereich des Schauglases (3) und/oder des Rohrstroboskops (4) eine Absaugvorrichtung vorgesehen ist, über die Schmutzpartikel aus dem Aufnahmeraum des Rohrstroboskops (4) absaugbar sind.

6. Vorrichtung nach einem oder mehreren der vorhergehenden Ansprüche, **dadurch gekennzeichnet**, daß der Abstand zwischen dem Außenumfang des Rohrstroboskops (4) und der Schauglas-Innenoberfläche mindestens 1 mm groß ist.

7. Vorrichtung nach einem oder mehreren der vorhergehenden Ansprüche, **dadurch gekennzeichnet**, daß das Rohrstroboskop (4) aus einem zylinderförmigen Rohrmantel (41) besteht, an dessen Enden sich je eine Scheibe (5) mit einer Nabe (34) befindet, die in in Flanschen (11) vorgesehenen Lagern drehbar aufgenommen sind.

8. Vorrichtung nach einem oder mehreren der vorhergehenden Ansprüche, **dadurch gekennzeichnet**, daß das Rohrstroboskop (4) bzw. die zugehörigen Teile des Rohrstroboskops (4) mit Auswuchtbohrungen versehen sind.

## Claims

1. Apparatus for the observation of processes, especially of processes in vacuum technology, with a viewing glass (3) disposed behind a chamber, past which a cylindrical, tubular, rotating device, which makes up a tubular stroboscope (4), moves in order to prevent contamination of the viewing glass (3), in which there are at least two diametrically opposite slit-shaped openings (24, 25) on the same plane, characterized in that the tubular stroboscope (4) is driven by a motor provided outside of the vacuum chamber or by a drive device having a gas-driven drive wheel (5) and in that the opening provided on one side of the tubular stroboscope (4) forms an entry opening (24) with a viewing cross section that is substantially smaller than the viewing cross section of the exit opening (25) that is on the diametrically opposite side.

2. Apparatus according to Claim 1, characterized in that the drive device consists of at least a drive wheel (5) configured as a bucket wheel and a jet nozzle (19) which directs inert gas against said drive wheel (5).

3. Apparatus according to Claim 1, characterized in that, in the circumferential direction of the tubular stroboscope (4), the entry opening (24) is at least 0.5 mm wide and the exit opening (25) is between 1 mm and 50 mm wide.

4. Apparatus according to one or more of the preceding claims, characterized in that the jet nozzle (19) is positioned at an angle with respect to the axis of rotation of the tubular stroboscope (4) and/or the drive wheel (5).

5. Apparatus according to one or more of the preceding claims, characterized in that an aspirator is provided near the viewing glass (3) and/or the tubular stroboscope (4), by means of which the dirt particles can be sucked away from the space containing the tubular stroboscope (4).

6. Apparatus according to one or more of the preceding claims, characterized in that the distance between the outer circumference of the tubular stroboscope (4) and the inside surface of the viewing glass is at least 1 millimeter.

7. Apparatus according to one or more of the preceding claims, characterized in that the tubular stroboscope (4) consists of a cylinder-shaped tube (41) at each of whose ends there is a wheel (5) with a hub (34), which is held rotatably in bearings located in flanges (11).

8. Apparatus according to one or more of the preceding claims, characterized in that the tubular stroboscope (4) or the appropriate parts of the tubular stroboscope (4) are provided with balancing holes.

## Revendications

1. Dispositif d'observation du déroulement de processus, notamment de processus de métallisation sous vide, comportant un verre d'observation (3) disposé derrière d'une chambre, auquel est apposé un corps tubulaire cylindrique qui constitue un stroboscope tubulaire (4), lequel effectue un mouvement de rotation pour éviter l'encrassement du verre d'observation (3) et dans lequel sont prévues au moins deux ouvertures en forme de fente (24, 25) diamétralement opposées et situées sur un même plan, le stroboscope tubulaire (4) pouvant être entraîné par un moteur situé au dehors de la chambre à vide ou par un dispositif d'entraînement présentant un disque d'entraînement (5) fonctionnant au gaz, la fente faisant office d'ouverture d'entrée (24) sur l'un des côtés du stroboscope tubulaire (4) présentant une section pour l'observation qui est beaucoup plus petite que la section d'observation offerte par l'ouverture côté sortie (25) située sur l'autre côté diamétralement opposé.

2. Disposisitf selon la revendication 1, caractérisé en ce que l'entraînement est constitué par au moins un disque d'entraînement (5) configuré comme roue à pales et d'une buse à jet de gaz (19) qui conduit du gaz inerte contre le disque d'entraînement (5).

3. Disposistif selon la revendication 1, caractérisé en ce qu'une ouverture d'entrée (24) d'au moins 0,5 mm et une ouverture de sortie (25) pouvant aller de 1 à 50 mm se trouvent sur le stroboscope (4), dans le sens du développement.

4. Dispositif selon l'une quelconque ou plusieurs des revendications ci-avant, caractérisé en ce que la buse à jet de gaz (19) est disposée selon un axe incliné par rapport à l'axe de rotation du stroboscope tubulaire (4) et/ou du disque d'entraînement (5).

5. Dispositif selon l'une quelconque ou plusieurs des revendications ci-avant, caractérisé en ce que dans la zone du verre d'observation (3) et/ou du stroboscope tubulaire (4) un dispositif d'aspiration est prévu qui permet d'aspirer dans l'enceinte de logement du stroboscope (4) les particules de crasse.

6. Dispositif selon l'une quelconque ou plusieurs des revendications ci-avant, caractérisé en ce que l'écart entre la surface cylindrique extérieure du stroboscope tubulaire (4) et la surface intérieure du verre d'observation (3) est d'au moins 1 mm.

7. Dispositif selon l'une quelconque ou plusieurs des revendications ci-avant, caractérisé en ce que le stroboscope tubulaire (4) consiste en un tube cylindrique (41) aux extrémités duquel se trouvent deux disques (5) comportant un moyeu (34) logés de façon rotative dans des paliers prévus dans des brides (11).

8. Dispositif selon l'une quelconque ou plusieurs des revendications ci-avant, caractérisé en ce que le stroboscope tubulaire (4) ou les pièces qui lui sont assorties sont dotées d'alésages pour l'équilibrage dynamique.
